# EUROPÄISCHE PATENTSCHRIFT

(11) **EP 1 078 456 B1**
(45) Veröffentlichungstag und Bekanntmachung des Hinweises auf die Patenterteilung: **24.07.2002**
(21) Anmeldenummer: 99927679.3
(22) Anmeldetag: 16.04.1999
(51) Int. Cl.: H03J 5/24, H03G 1/00

(54) **SCHALTUNGSANORDNUNG ZUR BEREICHSUMSCHALTUNG IN HOCHFREQUENZEMPFÄNGERN**
HIGH FREQUENCY RECEIVER RANGE SWITCHING CIRCUIT
CIRCUIT POUR SELECTION DE GAMMES DANS DES RECEPTEURS HAUTE FREQUENCE

(30) Priorität: 30.04.1998 DE 19819544
(43) Veröffentlichungstag der Anmeldung: 28.02.2001
(73) Patentinhaber: Infineon Technologies AG, 81669 München (DE)
(72) Erfinder: HOHMANN, Henning, D-81243 München (DE); PFLAUM, Bernd, D-82008 Unterhaching (DE)
(74) Vertreter: Fischer, Volker, Dipl.-Ing.
(86) Internationale Anmeldenummer: DE9901165
(87) Internationale Veröffentlichungsnummer: WO9957809

(56) Entgegenhaltungen:
- EP-A- 0 065 013
- EP-A- 0 457 932
- EP-A- 0 457 934
- US-A- 3 983 490
- US-A- 4 438 529

## Beschreibung

Die Erfindung betrifft eine Schaltungsanordnung zur Umschaltung der Empfangsbereiche in Hochfrequenzempfängern, insbesondere in Fernseh- und Rundfunkempfängern.

Hochfrequenzempfänger dienen zur Auswahl einer gewünschten Frequenz aus einem Gemisch aus einer Vielzahl dem Empfänger beispielsweise über eine Antenne zugeführten Frequenzen. Die gewünschte Frequenz wird von den restlichen empfangenden Frequenzen getrennt und das mit ihr übertragene Signal durch Demodulation gewonnen. Der Empfang verschiedener Fernseh- oder Rundfunkprogramme wird durch Abstimmung des Empfängers auf die Frequenz, mit der das jeweilige Programm ausgestrahlt wird, ermöglicht.

Die zu Übertragungszwecken benutzten Frequenzen sind in Bereiche eingeteilt, die als Frequenzbänder bezeichnet werden. Üblicherweise sind Empfänger auf ein Frequenzband oder mehrere Frequenzbänder einstellbar. Das hat den Vorteil, daß eine Empfangseinheit nicht für alle zu empfangenden Frequenzen ausgelegt sein muß, sondern Teilempfangseinheiten vorgesehen sein können, die jeweils nur ein Frequenzband abdecken. Die Abstimmkreise in den Teilempfangseinheiten sind dann auf das verhältnismäßig kleine Frequenzspektrum des jeweiligen Bandes optimiert.

Da nicht nur eine Empfangseinheit, der alle empfangbaren Frequenzen zugeführt werden, vorhanden ist, sondern eine der Teilempfangseinheiten je nach Frequenz, die detektiert werden soll, ausgewählt werden muß, ist eine Bereichsumschaltung notwendig. Mit der Bereichsumschaltung wird die Teilempfangseinheit aktiviert, die dem Frequenzbereich zugeordnet ist, in dem die gewünschte Frequenz liegt. Die von der jeweiligen Teilempfangseinheit detektierte Frequenz wird dann einer für alle Teilempfangseinheiten gemeinsamen Stufe zur weiteren Verarbeitung, beispielsweise Demodulation, zugeführt.

Die bei der Fernsehübertragung benutzten Frequenzen sind in drei Bänder unterteilt. Das untere VHF-Band (VHFI) umfaßt das Frequenzspektrum von 45 bis 126 MHz, das obere VHF-Band (VHFII) die Frequenzen 133 bis 407 MHz und das UHF-Band das Frequenzintervall von 415 bis 860 MHz. Für den VHF- und den UHF-Bereich werden in der Regel elektrisch unabhängige Teilempfangseinheiten eingesetzt, die bei vielen Empfängern je einen Mischer und einen Oszillator enthalten. Die Bereichsumschaltung erfolgt über bestimmte Steuersignale, die den gewünschten Mischer und Oszillator einschalten.

Schaltungsanordnungen zur Bereichsumschaltung in Tunern sind in der EP 0 457 934 und in der EP 0 457 932 beschrieben. Die Schaltungsanordnung nach der EP 0457 932 ist zur Bereichsumschaltung in Tunern mit mindestens zwei Bereichen ausgelegt. Für jeden Bereich ist eine MOS-Tetrode, die über eine Schalteinrichtung aktivierbar ist, vorgesehen. Die MOS-Tetrode einer der Vorstufen wird eingeschaltet, indem ihr Source-Anschluß über eine Schalteinrichtung mit dem Bezugspotential der Versorgungsspannung verbunden wird. Die jeweilige Vorstufe läßt sich also über die Höhe des Potentials am Source-Anschluß ihrer Tetrode aktivieren. Damit die Tetrode ausgeschaltet ist, wenn der Source-Anschluß nicht auf Bezugspotential liegt, muß über Spannungsteiler ein wohldefiniertes Potential an einem Gate-Anschluß und dem Source-Anschluß der Tetrode eingestellt werden.

Der Nachteil hierbei ist, daß für die Spannungsteiler Widerstände mit einem geringen Toleranzbereich benutzt werden müssen. Weiterhin ist nachteilig, daß das Ausgangssignal am Drain-Anschluß der Tetrode von der Dimensionierung der Spannungsteiler abhängig ist.

Aufgabe der vorliegenden Erfindung ist es daher, eine Schaltungsanordnung zur Bereichsumschaltung in Hochfrequenzempfängern anzugeben, die mit bisherigen Hochfrequenzempfängern funktions- und softwarecompatibel und deren Schaltungs- und Entwurfsaufwand gegenüber den bisher bekannten Schaltungen reduziert ist.

Diese Aufgabe wird durch eine Schaltungsanordnungen mit den Merkmalen des Patentanspruches 1 gelöst.

Die Erfindung hat den Vorteil, daß die Widerstände für den Spannungsteiler am Source-Anschluß entfallen. Dementsprechend verringert sich auch der Aufwand für die Dimensionierung. Schließlich läßt sich auch der Flächenaufwand für die erfindungsgemäße Schaltungsanordnung gegenüber herkömmlichen Schaltungsanordnungen reduzieren, was insbesondere bei Realisierungen als integrierter Schaltkreis von Bedeutung ist.

Weiterhin ist vorteilhaft, daß das Ausgangssignal der Halbleiterschaltelemente nicht von der Beschaltung des Source-Anschlusses abhängt.

Besonders vorteilhaft ist es, wenn als konstantes Potential das Bezugspotential der Versorgungsspannung verwendet wird. Potentialschwankungen können dann ohne zusätzliche Maßnahmen gering gehalten werden.

Vorteilhaft ist es auch, einen der Bereiche durch Zuschaltung eines Selektionskreises in Unterbereiche zu teilen. Insbesondere beim VHF-Band, das einen unteren und einen oberen Bereich aufweist, ist die Kopplung einer Verstärkerstufe mit dem Selektionskreis von Vorteil.

Weiterhin ist vorteilhaft, den Selektionskreis, der für den einen Bereich vorgesehen ist, so mit der Steuerelektrode des Halbleiterbauelementes für den anderen Bereich zu verbinden, daß der Selektionskreis nur dann aktiviert ist, wenn dieses Halbleiterbauelement ausgeschaltet ist. Dazu kann der Selektionskreis in der Art aktiviert werden, daß er mit dem Bezugspotential schaltbar verbunden ist und das Versorgungspotential ständig anliegt. Wird der Selektionskreis mit dem Bezugspotential verbunden, wird gleichzeitig die Steuerelektrode dieses Halbleiterbauelementes auf näherungsweise das Bezugspotential gebracht, wodurch es sperrt. Zur Schaltung können einfache npn-Transistoren, deren Emitter mit dem Bezugspotential verbunden sind, eingesetzt werden.

Weitere vorteilhafte Aus- und Weiterbildungen sind in Unteransprüchen gekennzeichnet.

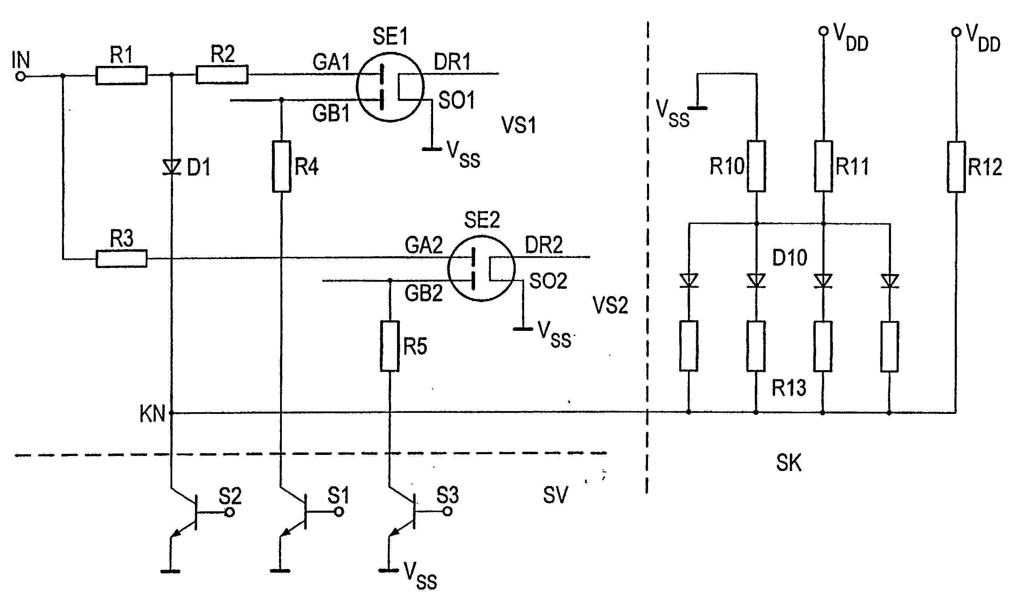

Die Erfindung wird nachfolgend anhand eines in der Figur dargestellten Ausführungsbeispiels näher erläutert. Die Figur zeigt:
Eine erfindungsgemäße Schaltungsanordnung.

Gemäß der Figur enthält die Schaltungsanordnung ein erstes Halbleiterschaltelement SE1, das Bestandteil einer ersten Verstärkerstufe VS1 ist, und ein zweites Halbleiterschaltelement SE2, das zu einer zweiten Verstärkerstufe VS2 gehört. Die Verstärkerstufen VS1, VS2 sind jeweils einem Frequenzband zugeordnet. Im Ausführungsbeispiel nach der Figur ist die erste Verstärkerstufe VS1 für das UHF-Band, die zweite Verstärkerstufe VS2 für das VHF-Band vorgesehen.

Die Halbleiterschaltelemente SE1, SE2 weisen jeweils zwei Steuerelektroden GA1, GB1, GA2 GB2 auf zur Steuerung eines Stroms in jeweils einem Hauptstrompfad zwischen einem Drain-Anschluß DR1, DR2 und einem Source-Anschluß SO1, SO2.

Ein Eingangsanschluß IN, über den ein Regelsignal der Schaltungsanordnung zugeführt wird, ist über zwei in Reihe geschaltete Widerstände R1, R2 mit der ersten Steuerelektrode GA1 des ersten Halbleiterschaltelementes SE1 verbunden. An den gemeinsamen Verbindungspunkt der Widerstände R1, R2 ist der Anodenanschluß einer Schaltdiode D1 angeschlossen. Der Kathodenanschluß der Schaltdiode D1 ist mit einem Knotenpunkt KN verbunden. Die zweite Steuerelektrode GB1 des ersten Halbleiterschaltelementes SE1, der ein erstes Hochfrequenzsignal zuführbar ist, ist über einen Widerstand R4, zu dem ein erster Schalter S1 in Reihe liegt, an einen Anschluß für ein Bezugspotential V_{SS} angeschlossen. Der Knotenpunkt KN ist über einen zweiten Schalter S2 ebenfalls mit dem Anschluß für das Bezugspotential V_{SS} verbunden. Ein dritter Schalter S3, verbindet den Anschluß für das Bezugspotential V_{SS} über einen Widerstand R5 mit der zweiten Steuerelektrode GB2 des zweiten Halbleiterschaltelements SE2. Die erste Steuerelektrode GA2 dieses Halbleiterschaltelements SE2 ist über einen Widerstand R3 mit dem Eingangsanschluß IN verbunden. Der zweiten Steuerelektrode GB2 ist ein zweites Hochfrequenzsignal zuführbar. Die Schalter S1, S2, S3 bilden zusammen eine Schaltvorrichtung SV. Sie können jeweils als npn-Transistoren, die emitterseitig mit dem Anschluß für das Bezugspotential V_{SS} verbunden sind, ausgeführt sein. Die Steuerung der Schaltvorrichtung erfolgt über die Basisanschlüsse der Transistoren S1, S2, S3.

Die Source-Anschlüsse SO1, SO2 der Halbleiterschaltelemente SE1, SE2 sind ebenfalls mit dem Anschluß für das Bezugspotential V_{SS} verbunden. Den Drain-Anschlüssen DR1, DR2 sind jeweils weitere Stufen des entsprechenden Frequenzbandes, die in der Figur nicht eingetragen sind, nachgeschaltet.

Der Knotenpunkt KN ist mit Umschaltwiderständen R13 und über einen Einstellwiderstand R12 mit einem Versorgungspotential V_{DD} verbunden. Die Umschaltwiderstände R13 sind jeweils mit. dem Kathodenanschluß einer Umschaltdiode D10, deren Anodenanschlüsse zusammengeschaltet sind, verbunden. Die zusammengeschalteten Anodenanschlüsse der Umschaltdioden D10 sind mit dem gemeinsamen Verbindungspunkt eines Spannungsteilers aus einem Widerstand R10 und einem Widerstand R11 verbunden. Der Spannungsteiler R10, R11 ist zwischen das Bezugspotential V_{SS} und das Versorgungspotential V_{DD} geschaltet.

Der Selektionskreis nach der Figur weist vier Umschaltwiderstände R13 mit vier dazugehörigen Umschaltdioden D10 auf. Jede der Verstärkerstufen VS1, VS2 enthält neben den Halbleiterschaltelementen SE1, SE2 jeweils Abstimmkreise, die in der Figur nicht eingetragen sind. Der Selektionskreis SK des Teilempfängers für das VHF-Band ermöglicht es mittels der Umschaltdioden D10 Induktivitäten des VHF-Teilempfängers in ihrer Resonanzfrequenz zwischen dem unteren und dem oberen VHF-Band umzuschalten. Die Induktivitäten sind in der Figur nicht eingezeichnet.

Die Bereichsumschaltung erfolgt durch bestimmte Steuersignale, die an die Schalter S1, S2, S3 der Steuervorrichtung SV angelegt werden. Im vorliegenden Ausführungsbeispiel werden digitale Steuersignale verwendet, die auf die Basisanschlüsse der npn-Transistoren S1, S2, S3 gegeben werden. Für jeden npn-Transistor ist jeweils ein eigenes digitales Steuersignal vorgesehen. Die digitalen Steuersignale weisen beispielsweise einen ersten Spannungspegel (Steuersignal low) auf, bei dem die npn-Transistoren sperren und einen zweiten Spannungspegel (Steuersignal high), bei dem sie leiten. Als Steuereingänge der npn-Transistoren werden die Basisanschlüsse benutzt.

Die Schaltungsanordnung nach der Figur ist so ausgelegt, daß das Steuersignal high zu einem bestimmten Zeitpunkt nur an genau einem der Schalter S1, S2, S3 angelegt werden darf. Die Schalter, denen nicht das Schaltsignal high zugeführt wird, werden mit dem Schaltsignal low angesteuert. Die Schalter S1, S2, S3 werden beispielsweise über eine Steuerlogik, die ein Mikroprozessor in einem Fernsehgerät ansteuert, angesprochen. Die Steuervorrichtung SV selbst kann als Teil eines PLL-Schaltkreises ausgeführt sein.

Je nach dem, an welchem Schalter S1, S2, S3 das Schaltsignal high anliegt, lassen sich drei Fälle unterscheiden. Dabei wird davon ausgegangen, daß die erste Verstärkerstufe VS1 für das UHF-Band und die zweite Verstärkerstufe VS2 für das VHF-Band ausgelegt ist.

Das UHF-Band wird aktiviert, indem dem dritten Schalter S3 das Steuersignal high und den Schaltern S1 und S2 das Steuersignal low zugeführt wird. Der Schalter S3 leitet dann und verbindet das Bezugspotential V_{SS} über den Widerstand R5 mit der zweiten Steuerelektrode GB2 des zweiten Halbleiterschaltelements SE2, wodurch dieses sperrt. Es kann nicht vom zweiten Hochfrequenzsignal, das über die zeite Steuerelektrode GB2 zugeführt wird, angesteuert werden. Diese zweite Verstärkerstufe VS2 für den VHF-Bereich ist also dann deaktiviert. Das erste Halbleiterschaltelement SE1 hingegen ist aktiviert, da seine zweite Steuerelektrode GB1 vom Bezugspotential V_{SS} getrennt ist und es über seine erste Steuerelektrode GA1 vom Regelsignal am Eingangsanschluß IN über den Pfad mit den Widerständen R1 und R2 und über seine zweite Steuerelektrode GB1 vom ersten Hochfrequenzsignal angesteuert wird. Der Pfad über die Schaltdiode D1 führt kein Signal, da der Schalter S2 geöffnet ist und an der Kathode der Schaltdiode D1 kein niedrigeres Potential liegt als an ihrer Anode.

Das untere VHF-Band (VHFI) wird aktiviert, indem dem ersten Schalter S1 das Steuersignal high und den übrigen Schaltern S2, S3 das Steuersignal low zugeführt wird. Über den Widerstand R4 ist dann die zweite Steuerelektrode GB1 des ersten Halbleiterschaltelements SE1 mit dem Bezugspotential V_{SS} verbunden, wodurch dieses sperrt. Es kann nicht über das Regelsignal an seiner ersten Steuerelektrode GA1 angesteuert werden. Das UHF-Band ist deaktiviert. Das zweite Halbleiterschaltelement SE2 hingegen wird von dem Regelsignal, das am Eingangsanschluß IN anliegt und über den Widerstand R3 der ersten Steuerelektrode GA2 zugeführt wird, angesteuert. Die zweite Steuerelektrode GB2 ist nicht mit niedrigem Potential verbunden. Das VHF-Band ist aktiviert. Da der Schalter S2 geöffnet ist, ist der Selektionskreis SK nicht aktiviert. Die zweite Verstärkerstufe VS2 wird dann auf das untere VHF-Band abgestimmt.

Das obere VHF-Band wird aktiviert, indem dem zweiten Schalter S2 das Steuersignal high und den übrigen Schaltern S1 und S3 das Steuersignal low zugeführt wird. Die Schaltdiode D1 schaltet, da ihre Kathode mit dem Bezugspotential V_{SS} verbunden ist und niedrigeres Potential aufweist als ihre Anode. Über die Schaltdiode D1 und den Widerstand R2 wird die erste Steuerelektrode GA1 des ersten Halbleiterschaltelements SE1 mit dem Bezugspotential V_{SS} verbunden. Dieses sperrt somit, und der UHF-Bereich ist deaktiviert. Das zweite Halbleiterschaltelement SE2 wird über die erste Steuerelektrode GA2 von dem Regelsignal am Eingangsanschluß IN sowie über seine zweite Steuerelektrode GB2 vom zweiten Hochfrequenzsignal angesteuert. Die zweite Steuerelektrode GB2 ist nicht mit dem Bezugspotential V_{SS} verbunden, der VHF-Bereich ist also aktiviert. Da der Schalter S2 geschlossen ist, liegt der Selektionskreis SK zwischen dem Bezugspotential V_{SS} und dem Versorgungspotential V_{DD}. Es fließt also ein Strom vom höheren Versorgungspotential zum niedrigeren Bezugspotential und der Selektionskreis ist aktiviert. Die zweite Verstärkerstufe VS2 wird auf das obere VHF-Band (VHFII) abgestimmt.

Es ist vorteilhaft, wenn das Regelsignal am Eingangsanschluß IN von einem AGC-Schaltkreis (automatic gain control) zur Verfügung gestellt wird. Eine solche Regelspannungsquelle gewährleistet durch Anpassung des Arbeitspunktes der jeweiligen Halbleiterschaltelemente SE1, SE2, daß unabhängig von der Feldstärke des beispielsweise über eine Antenne empfangenen Signals das Ausgangssignal der Verstärkerstufen VS1, VS2, nur geringen Schwankungen unterworfen ist. Der Wert des Widerstands R1 ist so groß zu wählen, daß bei geschlossenem Schalter S2 und somit einem Signalfluß vom Eingangsanschluß IN zum Bezugspotential V_{SS} der AGC-Schaltkreis nur gering belastet wird.

Der Widerstand R11 bildet mit dem Widerstand R10 des Selektionskreises SK einen Spannungsteiler, der das Potential an den Anoden der Umschaltdioden D10 auf einem Wert hält, der geringer ist, als das Versorgungspotential V_{DD}. Wenn der Schalter S2 geöffnet ist, sind dann die Umschaltdioden D10 gesperrt. Erst wenn der Schalter S2 geschlossen wird, also bei Aktivierung des oberen VHF-Bandes, wird das Kathodenpotential der Umschaltdioden D10 herabgesetzt und diese leiten. Angeschlossene Induktivitäten werden dadurch beispielsweise kurzgeschlossen und die Resonanzfrequenz des zugehörigen Abstimmkreises an das obere VHF-Band angepaßt.

Der Spannungsteiler R10, R11 kann auch durch eine Diode zwischen dem Versorgungspotential V_{DD} und den Anoden der Umschaltdioden D10 ersetzt werden.

Die Schaltdiode D1 entkoppelt den Selektionskreis SK von der ersten Steuerelektrode GA1 des ersten Halbleiterschaltelements SE1. Als Halbleiterschaltelement eignet sich ein Dual-Gate-MOSFET.

Die Schaltungsanordnung zur Bereichsumwandlung nach der Figur kann Teil eines Tuner-Ics mit Mischer-, Oszillator-, ZF-Vorverstärker- und PLL-Funktion sein.

## Patentansprüche

1. Schaltungsanordnung zur Bereichsumschaltung in Hochfrequenzempfängern mit zwei Bereichen, für die jeweils eine Verstärkerstufe (VS1, VS2) vorgesehen ist, die zur Auswahl eines der Bereiche mit einer Schaltvorrichtung (SV) jeweils aktivierbar ist, wobei die Verstärkerstufen (VS1, VS2) jeweils ein über zwei Steuerelektroden (GA1, GB1; GA2, GB2) ansteuerbares Halbleiterschaltelement (SE1, SE2) mit zwei über einen Hauptstrompfad verbundenen Anschlüssen (DR1, SO1; DR2, SO2) enthalten, **dadurch gekennzeichnet, daß** jeweils einer der Anschlüsse (SO1, SO2) unabhängig vom ausgewählten Bereich konstantes Potential aufweist und daß die Aktivierung der Verstärkerstufen (VS1, VS2) jeweils über eine der Steuerelektroden (GA1, GB1, GA2, GB2) des jeweiligen Halbleiterschaltelementes (SE1, SE2) erfolgt.

2. Schaltungsanordnung nach Anspruch 1, **dadurch gekennzeichnet, daß** dieser Anschluß (SO1, SO2) mit einem Bezugspotential (V_{SS}) der Versorgungsspannung verbunden ist.

3. Schaltungsanordnung nach einem der Ansprüche 1 oder 2, **dadurch gekennzeichnet, daß** die Verstärkerstufe (VS1) für den einen Bereich an einen Selektionskreis (SK) gekoppelt ist, mit dem die Eigenfrequenz des anderen Bereichs veränderbar ist.

4. Schaltungsanordnung nach Anspruch 3, **dadurch gekennzeichnet, daß** der Selektionskreis (SK) mit einer der Steuerelektroden (GA1) des Halbleiterschaltelements (SE1) der Verstärkerstufe (VS1) für den einen Bereich so verbunden ist, daß der Selektionskreis (SK) deaktiviert ist, wenn das Halbleiterschaltelement (SE1) über diese Steuerelektrode (GA1) leitend geschaltet ist.

5. Schaltungsanordnung nach einem der Ansprüche 3 oder 4, **dadurch gekennzeichnet, daß** der Selektionskreis (SK) eine Parallelschaltung von Reihenschaltungen, die jeweils eine Diode (D10) und einen Widerstand (R13) einschließen, aufweist.

6. Schaltungsanordnung nach einem der Ansprüche 1 bis 5, **dadurch gekennzeichnet, daß** als Halbleiterschaltelement (SE1, SE2) ein Dual-Gate-MOSFET vorgesehen ist.

7. Schaltungsanordnung nach einem der Ansprüche 3 bis 6, **dadurch gekennzeichnet, daß** die Schaltvorrichtung (SV) einen ersten (S1), einen zweiten (S2) und einem dritten (S3) Schalter aufweist, daß über den zweiten Schalter (S2) die eine Steuerelektrode (GA1) des Halbleiterschaltelements (SE1) der Verstärkerstufe (VS1) für den einen Bereich sowie ein Anschluß (KN) des Selektionskreises (SK) mit dem Bezugspotential (V_{SS}) verbunden ist, daß über den ersten Schalter (S1) die andere Steuerelektrode (GB1) dieses Halbleiterschaltelements (SE1) mit dem Bezugspotential (V_{SS}) verbunden ist und daß über den dritten Schalter (S3) die eine Steuerelektrode (GB2) des Halbleiterschaltelements (SE2) der Verstärkerstufe (VS2) für den anderen Bereich mit dem Bezugspotential (V_{SS}) verbunden ist.

8. Schaltungsanordnung nach Anspruch 7, **dadurch gekennzeichnet, daß** die eine Steuerelektrode (GA1) des Halbleiterschaltelements (SE1) der Verstärkerstufe (VS1) für den einen Bereich über eine Schaltdiode (D1) mit dem zweiten Schalter (S2) verbunden ist.

## Claims

1. Circuit arrangement for range switchover in radio frequency receivers with two ranges, for which an amplifier stage (VS1, VS2) is in each case provided which can be activated in each case with a switching device (SV) in order to select one of the ranges, the amplifier stages (VS1, VS2) in each case containing a semiconductor switching element (SE1, SE2) which can be controlled via two control electrodes (GA1, GB1; GA2, GB2) with two terminals (DR1, SO1; DR2, SO2) connected via a main current path, **characterized in that** one of the terminals (SO1, SO2), irrespective of the selected range, in each case has constant potential and **in that** the amplifier stages (VS1, VS2) are in each case activated via one of the control electrodes (GA1, GB1, GA2, GB2) of the respective semiconductor switching element (SE1, SE2).

2. Circuit arrangement according to Claim 1, **characterized in that** this terminal (SO1, SO2) is connected to a reference potential (V_{SS}) of the supply voltage.

3. Circuit arrangement according to one of Claims 1 or 2, **characterized in that** the amplifier stage (VS1) is connected for one range to a selection circuit (SK), with which the natural frequency of the other range can be modified.

4. Circuit arrangement according to Claim 3, **characterized in that** the selection circuit (SK) is connected to one of the control electrodes (GA1) of the semiconductor switching element (SE1) of the amplifier stage (VS1) for one range in such a way that the selection circuit (SK) is deactivated when the semiconductor switching element (SE1) is switched to conduct via this control electrode (GA1).

5. Circuit arrangement according to one of Claims 3 or 4, **characterized in that** the selection circuit (SK) has a parallel connection of series circuits, which in each case include a diode (D10) and a resistor (R13).

6. Circuit arrangement according to one of Claims 1 to 5, **characterized in that** a dual-gate MOSFET is provided as the semiconductor switching element (SE1, SE2).

7. Circuit arrangement according to one of Claims 3 to 6, **characterized in that** the switching device (SV) has a first (S1), a second (S2) and a third (S3) switch, one control electrode (GA1) of the semiconductor switching element (SE1) of the amplifier stage (VS1) and a terminal (KN) of the selection circuit (SK) are connected for one range via the second switch (S2) to the reference potential (V_{SS}), **in that** the other control electrode (GB1) of this semiconductor switching element (SE1) is connected via the first switch (S1) to the reference potential (V_{SS}), and **in that** one control electrode (GB2) of the semiconductor switching element (SE2) of the amplifier stage (VS2) is connected for the other range via the third switch (S3) to the reference potential (V_{SS}).

8. Circuit arrangement according to Claim 7, **characterized in that** one control electrode (GA1) of the semiconductor switching element (SE1) of the amplifier stage (VS1) is connected for one range via a switching diode (D1) to the second switch (S2).

## Revendications

1. Circuit de sélection de gammes dans des récepteurs haute fréquence, comprenant deux gammes pour lesquelles il est prévu respectivement un étage (VS1, VS2) amplificateur qui peut être activé respectivement pour sélectionner l'une des gammes par un dispositif (SV) de commutation, les étages (VS1, VS2) amplificateurs comportant respectivement un élément (SE1, SE2) de commutation à semi-conducteur pouvant être commandé par deux électrodes (GA1, GB1 ; GA2, GB2) de commande et ayant deux bornes (DR1, SO1 ; DR2, SO2) reliées par un trajet de courant principal, **caractérisé en ce que** respectivement l'une des bornes (SO1, SO2) a un potentiel constant indépendamment de la gamme sélectionnée et **en ce que** l'activation des étages (VS1, VS2) amplificateurs s'effectue respectivement par l'une des électrodes (GA1, GB1, GA2, GB2) de commande de l'élément (SE1, SE2) de commutation à semi-conducteur respectif.

2. Circuit suivant la revendication 1, **caractérisé en ce que** cette borne (SO1, SO2) est reliée à un potentiel (V_{SS}) de référence de la tension d'alimentation.

3. Circuit suivant l'une des revendications 1 ou 2, **caractérisé en ce que** l'étage (VS1) amplificateur pour l'une des gammes est couplé à un circuit (SK) de sélection, par lequel la fréquence propre de l'autre gamme peut être modifiée.

4. Circuit suivant la revendication 3, **caractérisé en ce que** le circuit (SK) de sélection est relié à l'une des électrodes (GA1) de commande de l'élément (SE1) à semi-conducteur de l'étage (VS1) amplificateur pour l'une des gammes de façon que le circuit (SK) de sélection soit désactivé lorsque l'élément (SE1) de commutation à semi-conducteur est rendu passant par cette électrode (GA1) de commande.

5. Circuit suivant Tune des revendications 3 ou 4, **caractérisé en ce que** le circuit de sélection (SK) comprend un circuit parallèle de circuits série qui incluent respectivement une diode (D10) et une résistance (R13).

6. Circuit suivant rune des revendications 1 à 5, **caractérisé en ce qu'**il est prévu comme élément (SE1, SE2) de commutation à semi-conducteur un MOSFET Dual-Gate.

7. Circuit suivant l'une des revendications 3 à 6, **caractérisé en ce que** le dispositif (SV) de commutation comprend un premier (S1), un deuxième (S2) et un troisième (S3) commutateurs, **en ce que** par le deuxième commutateur (S2) Tune des électrodes (GA1) de commande de l'élément (SE1) de commutation à semi-conducteur de l'étage (VS1) amplificateur pour Tune des gammes ainsi qu'une borne (KN) du circuit (SK) de sélection est reliée au potentiel (V_{SS}) de référence, **en ce que** par le premier commutateur (S1) l'autre électrode (GB1) de commande de cet élément (SE1) de commutation à semi-conducteur est reliée au potentiel (V_{SS}) de référence et **en ce que** par le troisième commutateur (S3), l'une des électrodes (GB2) de commande de l'élément (S2) de commutation à semi-conducteur de l'étage (VS2) amplificateur pour l'autre gamme est reliée au potentiel (V_{SS}) de référence.

8. Circuit suivant la revendications 7, **caractérisé en ce que** l'une des électrodes (GA1) de commande de l'élément (SE1) de commutation à semi-conducteur de l'étage (VS1) amplificateur pour l'une des gammes est reliée par une diode (D1) de commutateur au deuxième commutateur (S2).
